# EUROPEAN PATENT SPECIFICATION

(11) **EP 0 495 294 B1**
(45) Date of publication and mention of the grant of the patent: **24.05.1995**
(21) Application number: 91310019.4
(22) Date of filing: 30.10.1991
(51) Int. Cl.: H01L 21/00, F27D 15/02

(54) **Semiconductor device manufacturing apparatus and method of controlling the heat processing of wafers**
Vorrichtung zur Herstellung von Halbleitern und Verfahren zur Kontrolle der thermischen Behandlung von Wafers
Dispositif pour la fabrication de semi-conducteurs et procédé pour contrôler le traitement thermique des galettes

(30) Priority: 17.01.1991 JP 15679/91
(43) Date of publication of application: 22.07.1992
(73) Proprietor: MITSUBISHI DENKI KABUSHIKI KAISHA, Tokyo (JP)
(72) Inventor: Hashizume, Yasushi, 1,Mizuhara 4-chome, Itami-shi, Hyogo-ken (JP); Tomikawa, Mitsuhiro, 1,Mizuhara 4-chome, Itami-shi, Hyogo-ken (JP)
(74) Representative: Beresford, Keith Denis Lewis

(56) References cited:
- US-A- 4 766 678
- US-A- 4 957 781
- PATENT ABSTRACTS OF JAPAN, vol. 11, no. 227 (E-526), 23 July 1987 & JP-A-62 045 020
- PATENT ABSTRACTS OF JAPAN, vol. 14, no. 573 (E-101), 19 December 1990 & JP-A-02 248 039

## Description

### BACKGROUND OF THE INVENTION

### FIELD OF THE INVENTION:

The present invention relates to a semiconductor device manufacturing apparatus and method for heat processing semiconductor wafers.

### DESCRIPTION OF THE RELATED ART:

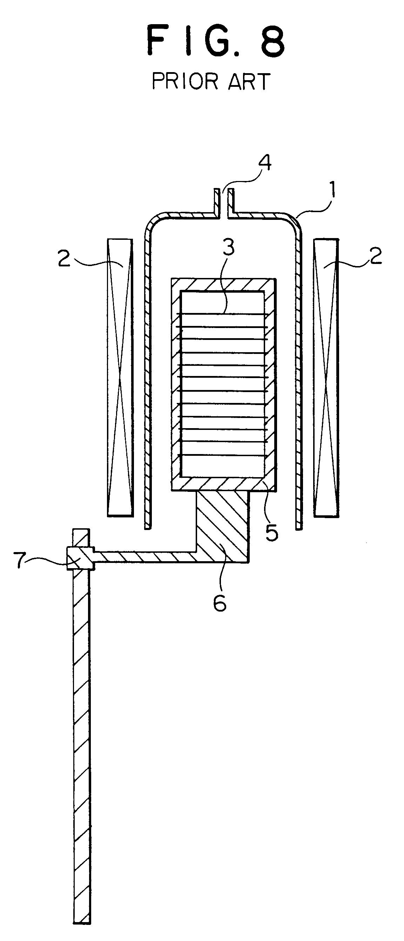

Fig. 8 is a schematic view of a conventional semiconductor device manufacturing apparatus, for example, a diffusion furnace. In Fig. 8, a heater 2 is disposed on the outside of a cylindrical processing chamber 1 made of quartz. The cylindrical processing chamber 1 has an opening at its lower end. An upper portion of the processing chamber 1 is provided with a gas introducing port 4. Within the processing chamber 1, a plurality of semiconductor wafers are supported on, for example, a boat 5 made of quartz. The boat 5 is placed on a boat base 6, which is connected to a boat loader 7. The boat 5 is fed in and out of the processing chamber 1 by the vertical movement of the boat loader 7.

The conventional semiconductor device manufacturing apparatus arranged in the manner described above is operated as follows: first, the semiconductor wafers 3 to be heated are placed on the boat 5, and that boat is accommodated in the processing chamber 1 by means of the boat loader 7. Thereafter, the semiconductor wafers 3 are heated by the heater 2 while gas, such as oxygen or nitrogen, is supplied from the gas introducing port 4, when necessary. After heating has been conducted for a desired period of time and at a desired temperature, the boat 5 is pulled out of the processing chamber 1 by means of the boat loader 7.

Generally, the semiconductor wafers 3 are pulled out of the processing chamber 1 at a very high temperature ranging from 800°C to 900°C, because it takes long time for the temperature of the diffusion furnace to decrease due to the large heat capacity thereof and pulling out of the semiconductor wafers 3 at a low temperature lengthens the processing time and thus reduces productivity.

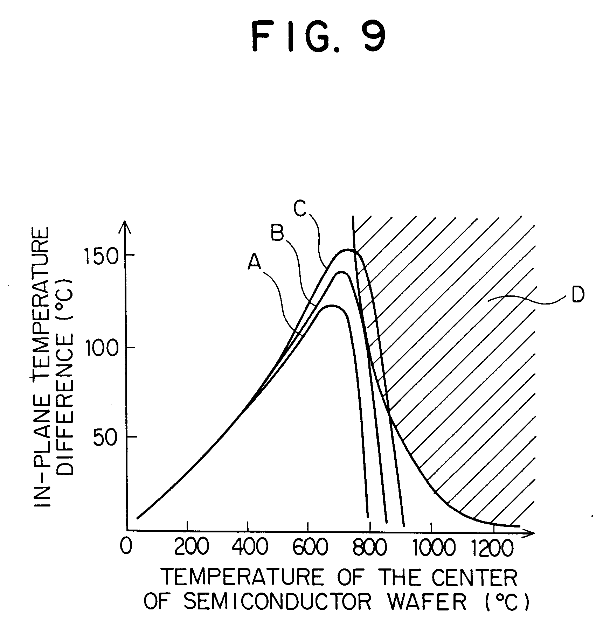

Pulled out of the high temperature processing chamber 1, the semiconductor wafers 3 begin to cool starting from the periphery thereof. Fig. 9 is a graph showing how the temperature of the wafers behaves at various temperatures of the processing chamber 1 when they are pulled out of the chamber. The abscissa axis represents the temperature of the center of the semiconductor wafer 3, and the ordinate axis represents the difference in the temperature between the center of and the periphery of the semiconductor wafer 3. In the graph, curves A, B, and C respectively show the behaviour of the temperature of the semiconductor wafer 3 when they are pulled out of the chamber 1 at 800°C, 850°C and 900°C. As can be seen from the graph, the presence of the difference in the temperature between the centre and the periphery of the semiconductor wafer 3 generates stress. When the temperature of the processing chamber 1 is high while the temperature difference of the semiconductor wafer 3 is large, crystal defects or dislocations occur to a degree which cannot be repaired. The area where defects or dislocations occur is represented by a plastically deformed area D. The graph shown in Fig. 9 is just an example, and the temperature difference increases in a case where the semiconductor wafer 3 has a larger diameter or where the pulling rate of the semiconductor wafer 3 is higher.

In the semiconductor device manufacturing apparatus of the type described above, the difference in the temperature between the centre and periphery of the semiconductor wafer 3 is great when the semiconductor wafer is pulled out of the processing chamber 1, generating crystal defects or dislocations and thereby deteriorating the performance of the semiconductor wafer 3.

This problem has been addressed in Patent Abstracts of Japan, Vol. 14, No. 573 (E-101) 19 December 1990 and Japanese Kokai JP-A-02248039. As therein described the wafers are mounted in a semi-cylindrical holder and are enclosed therein by a heat insulative semi-cylindrical cover which fits over the wafers.

### SUMMARY OF THE INVENTION

Accordingly, an object of the present invention is to provide a semiconductor device manufacturing apparatus which enables a difference in the in-plane temperature of a semiconductor wafer to be maintained small when the semiconductor wafer is pulled out of a processing chamber so as to eliminate generation of crystal defects or dislocations in the semiconductor wafer.

Another object of the present invention is to provide a method of heat processing semiconductor wafers.

In order to achieve the above objects, according to one aspect of the present invention, there is provided a semiconductor device manufacturing apparatus which comprises a processing chamber for heat processing semiconductor wafers, a heater disposed on the outside of the processing chamber for heating, a jig for holding the plurality of semiconductor wafers and guiding them into and out of the processing chamber, and a heat retaining tube that can be placed in and pulled out of the processing chamber independently from the jig, the heat retaining tube being open at each end and having throughout a diameter which allows it to surround the semiconductor wafers without impeding insertion of the wafers therein.

According to another aspect of the present invention, there is provided a method of heat processing semiconductor wafers which method comprises the steps of placing a heat retaining tube which is open at each end in a processing chamber and heating the interior of the processing chamber, inserting a boat with semiconductor wafers placed thereon through an open end of said heat retaining tube while it is in the processing chamber and then heat processing the semiconductor wafers, pulling out the heat retaining tube and the boat with the semiconductor wafers placed thereon from the processing chamber at the same time, and removing the heat retaining tube from the vicinity of the semiconductor wafers when the temperature of the semiconductor wafers has fallen to below a level at which plastic deformation thereof would occur.

While a heat retaining tube which is open at each end is provided as specified above, it is mentioned that cylindrical bodies, in particular capping members having cylindrical portions, are used in heat processing apparatus. In United States Patent US 4957781 there is disclosed a capping member having an elongate cylindrical portion of diameter larger than the diameter of a cylindrical processing chamber. The capping member is slidably engaged on a shaft which is part of the jig of the wafer holder. The open end of the cylindrical portion of the capping member can thus be passed over the lower end of the processing chamber before the wafers are introduced into the processing chamber. Flow of air into the chamber is thus impeded immediately before the wafers are introduced into the processing chamber as well as while the wafers are retained therein. Such capping members can also have a diameter smaller than the diameter of the cylindrical processing chamber, as shown in United States Patent US 4766678.

### BRIEF DESCRIPTION OF THE DRAWINGS

Fig. 1 is a cross-sectional view of an embodiment of a semiconductor device manufacturing apparatus according to the present invention;
Fig. 2 is a schematic view showing the state before the heat process in a method of heat processing semiconductor wafers according to the present invention;
Fig. 3 is a schematic view showing the state in the midst of the heat process in the method according to the present invention;
Fig. 4 is a schematic view showing the state after heat processing in the method according to the present invention;
Fig. 5 is a schematic view showing the state after the semiconductor wafers are cooled in the method according to the present invention;
Fig. 6 is a cross-sectional view of another embodiment of the semiconductor device manufacturing apparatus according to the present invention;
Fig. 7 is a cross-sectional view of still another embodiment of the semiconductor device manufacturing apparatus according to the present invention;
Fig. 8 is a cross-sectional view of a conventional semiconductor device manufacturing apparatus; and
Fig. 9 is a graph showing the relation between the temperature of the centre of a semiconductor wafer and the difference in the in-plane temperature thereof.

### DESCRIPTION OF THE PREFERRED EMBODIMENT

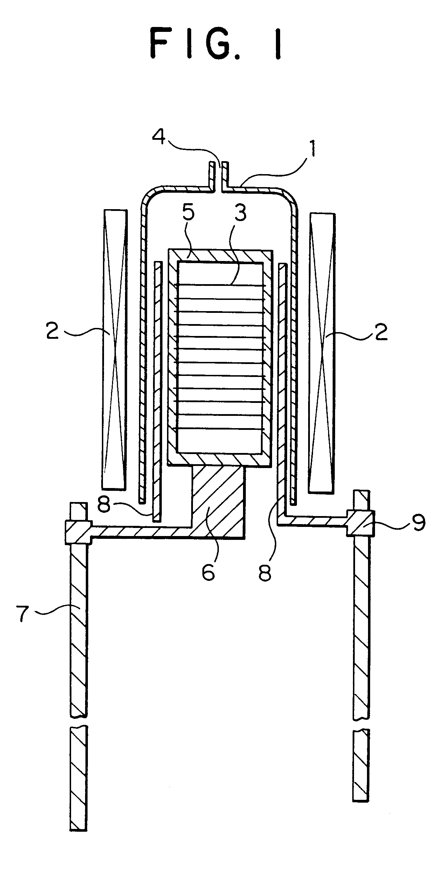

Fig. 1 is a cross-sectional view of an embodiment of a semiconductor device manufacturing apparatus according to the present invention. In Fig. 1, reference numerals 1 to 7 denote the parts which are the same as those of the conventional semiconductor device manufacturing apparatus shown in Fig. 8. In this semiconductor device manufacturing apparatus, a means for retaining the heat of the semiconductor wafers 3, i.e. a heat retaining tube 8 which is open at each end, is provided around the boat 5. The heat retaining tube 8 is made of, for example, quartz. The heat retaining tube 8 is placed in and pulled out of the processing chamber by means of a driving mechanism. The heat retaining tube 8 has at least a length which ensures that it surrounds the semiconductor wafer row.

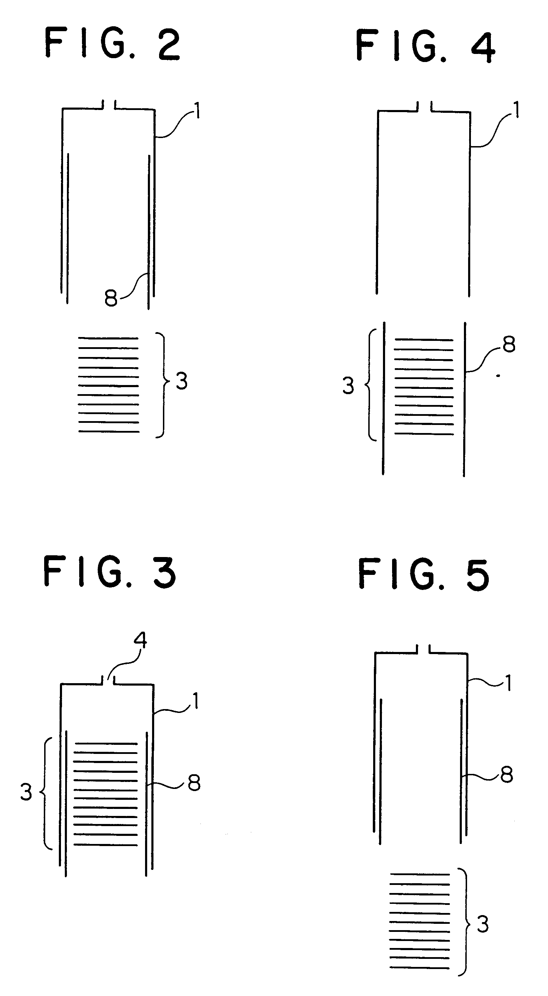

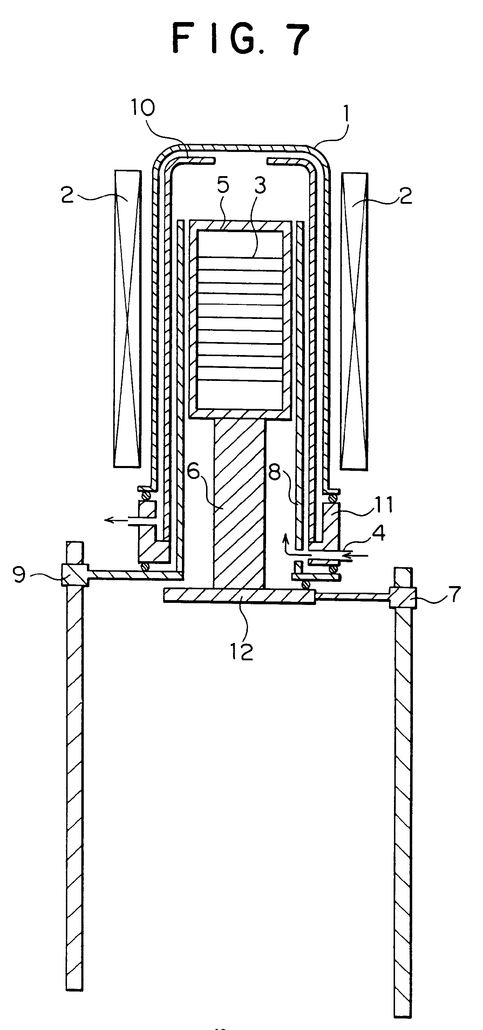

The semiconductor device manufacturing apparatus is operated in the manner described below: first, the semiconductor wafers 3 to be heated are placed on the boat 5. At that time, the heat retaining tube 8 is already located in the processing chamber 1, as shown in Fig. 2. The heat retaining tube 8 is placed in the processing chamber 1 before the accommodation of the boat in the chamber 1 because concurrent supply of the heat retaining tube 8 and boat 5 reduces the internal temperature of the processing chamber 1 due to the large heat capacity of the heat retaining tube 8. Next, the boat 5 with the semiconductor wafers 3 mounted thereon is accommodated in the processing chamber 1 by means of the boat loader 7, as shown in Fig. 7. In Fig. 3, illustration of the boat 5 and boat loader 7 are omitted. Thereafter, the semiconductor wafers 3 are heated by means of the heater 2 (not shown) while gas, such as oxygen or nitrogen, is supplied from the gas introducing port 4, when necessary.

After the heating has been conducted for a desired period of time and at a desired temperature, the boat 5 is pulled out of the processing chamber 1 by means of the boat loader 7. At that time, the heat retaining tube 8 is also pulled out of the processing chamber 1 together with the boat 5, as shown in Fig. 4. In a case where the boat 5 and the heat retaining tube 8 are pulled out of the processing chamber 1 concurrently, the rate at which the temperature of the peripheral portion of the semiconductor wafer 3 drops is decreased because of the radiant heat emitted from the heat retaining tube 8, and an increase in the difference in the temperature between the periphery and centre of the semiconductor wafer 3 can thus be suppressed. When the temperature of the semiconductor 3 has dropped to about 700°C, at which the plastically deformed area D shown in Fig. 5 where crystal defects or dislocations do not occur in the semiconductor wafer 3, does not exist, the heat retaining tube 8 is returned to the processing chamber 1, as shown in Fig.5). The semiconductor wafers 3 and the heat retaining tube 8 can thus be separated when the temperature of the wafers has decreased to a value at which the plastically deformed area D does not exist, even through they are not cooled completely, and this shortens the processing time. Next, the semiconductor wafers 3 are unloaded from the boat 5 when they have been sufficiently cooled.

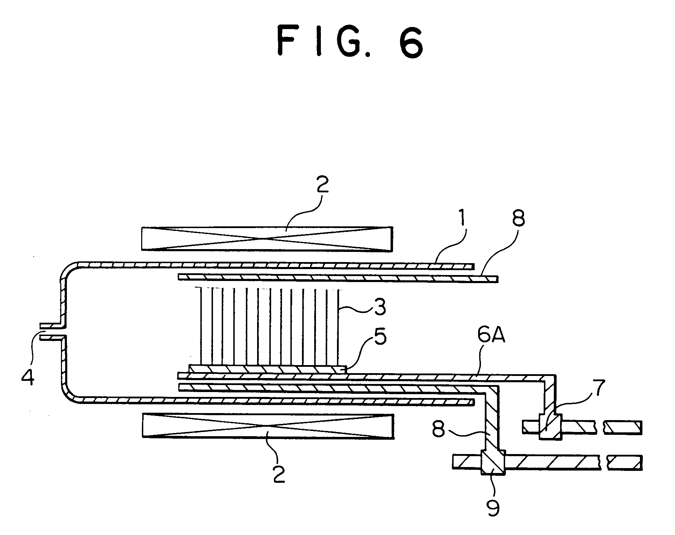

In the above-described embodiment, a vertical type processing chamber 1 is used. However, a horizontal type processing chamber 1, such as that shown in Fig. 6 may also be used. At that time, a cantipaddle 6A is used in place of the boat base 6.

In the aforementioned embodiment, the diffusion furnace has been described. However, the present invention is not limited to this, but can be applied to any heating apparatus having a cylindrical processing chamber, such as a vacuum vapour-phase apparatus shown in Fig. 7. The vapour-phase apparatus shown in Fig. 7 has an inner tube 10 and a flange 11 within the processing chamber 1 in order to achieve vacuum state. The board base 6 is retained by a door 12. In the case shown in Fig. 7, the heat retaining tube 8 and the inner tube 10 are provided as the individual components. However, a heat retaining tube which has the two functions may also be provided.

In the above-described embodiment, the heat retaining tube 8 is made of quartz. However, it can be made of any substance which does not affect the semiconductor wafers 3 during heating, e.g., which does not supply impurities. For example, a heat retaining tube 8 made of SiC or Si may be used.

## Claims

1. A semiconductor device manufacturing apparatus comprising:
a processing chamber (1) for heat processing a plurality of semiconductor wafers (3);
a heater (2) disposed on the outside of said processing chamber (1) for heating;
a jig (5-7) for holding the plurality of semiconductor wafers (3) and guiding them into and out of said processing chamber (1);
which apparatus is characterised by:
a heat retaining tube (8) that can be placed in and pulled out of said processing chamber (1) independently from said jig (5-7), said heat retaining tube (8) being open at each end and having throughout a diameter which allows it to surround the semiconductor wafers (3), without impeding passage of the wafers (3) therethrough.

2. A semiconductor device manufacturing apparatus according to claim 1, wherein said heat retaining tube (8) has at least a length which allows it to surround the plurality of semiconductor wafers (3).

3. A semiconductor device manufacturing apparatus according to claim 1, wherein said heat retaining tube (8) is made of quartz.

4. A semiconductor device manufacturing apparatus according to claim 1, wherein said heat retaining tube (8) is made of SiC.

5. A semiconductor device manufacturing apparatus according to claim 1, wherein said heat retaining tube (8) is made of Si.

6. A semiconductor device manufacturing apparatus according to claim 1, wherein said semiconductor device manufacturing apparatus comprises a diffusion furnace (1,2).

7. A semiconductor device manufacturing apparatus according to claim 1, wherein said semiconductor device manufacturing apparatus comprises a vacuum vapour-phase apparatus (1-12).

8. A method of heat processing semiconductor wafers which method comprises the steps of:
placing a heat retaining tube (8) which is open at each end in a processing chamber (1) and heating the interior of said processing chamber (1);
inserting a boat (5) with semiconductor wafers (3) placed thereon through an open end of said heat retaining tube (8) while it is in said processing chamber (1) and then heat processing the semiconductor wafers (3);
pulling out said heat retaining tube (8) and said boat (5) with the semiconductor wafers (3) placed thereon from said processing chamber (1) at the same time; and
removing said heat retaining tube (8) from the vicinity of the semiconductor wafers (3) when the temperature of the semiconductor wafers (3) has fallen to below a level at which crystal defects such as dislocations thereof would occur.

## Patentansprüche

1. Vorrichtung zum Herstellen von Halbleitereinrichtungen, die folgendes aufweist:
- eine Bearbeitungskammer (1) zur Wärmebehandlung einer Vielzahl von Halbleiterwafern (3);
- eine Heizeinrichtung (2), die außerhalb der Bearbeitungskammer (1) zum Heizen angeordnet ist;
- eine Spanneinrichtung (5 bis 7), um die Vielzahl von Halbleiterwafern (3) zu halten und sie in die Bearbeitungskammer (1) hinein und aus dieser heraus zu führen,
wobei die Vorrichtung gekennzeichnet ist durch:
- ein Wärmespeicherrohr (8), das unabhängig von der Spanneinrichtung (5 bis 7) in die Bearbeitungskammer (1) eingebracht und aus dieser herausgezogen werden kann, wobei das Wärmespeicherrohr (8) an jedem Ende offen ist und durchgehend einen Durchmesser besitzt, der es ermöglicht, die Halbleiterwafer (3) zu umgeben, ohne den Durchgang der Wafer (3) durch sie hindurch zu beeinträchtigen.

2. Vorrichtung zur Herstellung von Halbleitereinrichtungen nach Anspruch 1,
wobei das Wärmespeicherrohr (8) zumindest eine Länge besitzt, die es ermöglicht, die Vielzahl von Halbleiterwafern (3) zu umgeben.

3. Vorrichtung zur Herstellung von Halbleitereinrichtungen nach Anspruch 1,
wobei das Wärmespeicherrohr (8) aus Quarz besteht.

4. Vorrichtung zur Herstellung von Halbleitereinrichtungen nach Anspruch 1,
wobei das Wärmespeicherrohr (8) aus SiC besteht.

5. Vorrichtung zur Herstellung von Halbleitereinrichtungen nach Anspruch 1,
wobei das Wärmespeicherrohr (8) aus Si besteht.

6. Vorrichtung zur Herstellung von Halbleitereinrichtungen nach Anspruch 1,
wobei die Vorrichtung einen Diffusionsofen (1, 2) aufweist.

7. Vorrichtung zur Herstellung von Halbleitereinrichtungen nach Anspruch 1,
wobei die Vorrichtung eine Vakuumdampfphasenvorrichtung (1 bis 12) aufweist.

8. Verfahren zur Wärmebehandlung von Halbleiterwafern,
wobei das Verfahren folgende Schritte aufweist:
- Anbringen eines Wärmespeicherrohres (8), das an jedem Ende offen ist, in einer Bearbeitungskammer (1) und Beheizen des Innenraumes der Bearbeitungskammer (1) ;
- Einsetzen eines Schiffchens (5) mit darauf angeordneten Halbleiterwafern (3) durch ein offenes Ende des Wärmespeicherrohres (8), während es sich in der Bearbeitungskammer (1) befindet, und anschließende Wärmebehandlung der Halbleiterwafer (3);
- gleichzeitiges Herausziehen des Wärmespeicherrohres (8) und des Schiffchens (5) mit den darauf angeordneten Halbleiterwafern (3) aus der Bearbeitungskammer (1); und
- Entfernen des Wärmespeicherrohres (8) aus der Nähe der Halbleiterwafer (3), wenn die Temperatur der Halbleiterwafer (3) auf einen Wert unter einen Pegel gefallen ist, bei dem Kristalldefekte, wie z. B. Kristallversetzungen auftreten können.

## Revendications

1. Appareil de fabrication de dispositifs semi-conducteurs comprenant :
une chambre de traitement (1) pour traiter à la chaleur une pluralité de plaquettes semi-conductrices (3);
un dispositif de chauffage (2) disposé à l'extérieur de la chambre de traitement (1) pour assurer le chauffage;
un bras de support (5-7) pour maintenir la pluralité de plaquettes semi-conductrices (3) et les guider vers l'intérieur et l'extérieur de la chambre de traitement (1);
lequel appareil est caractérisé par :
un tube de retenue de chaleur (8) qui peut être placé dans et retiré de ladite chambre de traitement (1) indépendamment dudit bras de support (5-7), ledit tube de retenue de chaleur (8) étant ouvert à chaque extrémité et ayant sur toute sa longueur un diamètre qui lui permet d'entourer les plaquettes semi-conductrices (3), sans empêcher le passage des plaquettes (3) à travers lui.

2. Appareil de fabrication de dispositifs semi-conducteurs selon la revendication 1, dans lequel le tube de retenue de chaleur (8) a au moins une longueur qui lui permet d'entourer la pluralité de plaquettes semi-conductrices (3).

3. Appareil de fabrication de dispositifs semi-conducteurs selon la revendication 1, dans lequel le tube de retenue de chaleur précité (8) est réalisé en quartz.

4. Appareil de fabrication de dispositifs semi-conducteurs selon la revendication 1, dans lequel le tube de retenue de chaleur (8) est réalisé en SiC.

5. Appareil de fabrication de dispositifs semi-conducteurs selon la revendication 1, dans lequel le tube de retenue de chaleur (8) précité est réalisé en Si.

6. Appareil de fabrication de dispositifs semi-conducteurs selon la revendication 1, dans lequel l'appareil de fabrication de dispositifs semi-conducteurs précité comprend un four à diffusion (1,2).

7. Appareil de fabrication de dispositifs semi-conducteurs selon la revendication 1, dans lequel ledit appareil de fabrication de dispositifs semi-conducteurs comprend un appareil à phase vapeur sous vide (1-12).

8. Procédé de traitement à la chaleur de plaquettes semi-conductrices, lequel procédé comprend les opérations de :
placer un tube de retenue de chaleur (8) qui est ouvert à chaque extrémité dans une chambre de traitement (1) et chauffer l'intérieur de ladite chambre de traitement (1);
insérer une nacelle (5) dans laquelle sont disposées des plaquettes semi-conductrices (3) à travers une extrémité ouverte dudit tube de retenue de chaleur (8) tandis qu'il est à l'intérieur de ladite chambre de traitement (1) et traiter ensuite à la chaleur les plaquettes semi-conductrices (3);
retirer ledit tube de retenue de chaleur (8) et ladite nacelle (5) avec les plaquettes semi-conductrices (3) disposées sur elle simultanément de la chambre de traitement (1); et
retirer ledit tube de retenue de chaleur (8) du voisinage des plaquettes semi-conductrices (3) lorsque la température des plaquettes semi-conductrices (3) est tombée en dessous d'un niveau auquel des défauts de cristal, tels qu'une dislocation, puissent se produire.
